(19) Europäisches Patentamt
European Patent Office
Office européen des brevets

(11) EP 2 479 887 A1

(12) EUROPEAN PATENT APPLICATION

(43) Date of publication:
25.07.2012 Bulletin 2012/30

(51) Int Cl.:
*H03C 1/46* (2006.01)   *H03H 9/54* (2006.01)

(21) Application number: 11290027.9

(22) Date of filing: 19.01.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: Alcatel Lucent
75007 Paris (FR)

(72) Inventors:
• Wiegner, Dirk
  71409 Schwaikheim (DE)

• Templ, Wolfgang Dr.
  74372 Sersheim (DE)

(74) Representative: Dreiss
Patentanwälte
Postfach 10 37 62
70032 Stuttgart (DE)

Remarks:
Amended claims in accordance with Rule 137(2)
EPC.

(54) **Electro-mechanical radio frequency signal generator and method of operating an electro-mechanical radio frequency signal generator**

(57)     The invention relates to a radio frequency, RF, signal generator (100), for providing an RF signal (RF_out), said RF signal generator (100) comprising:
- at least two coupling elements (2; 41; 51), wherein each coupling element (2; 41; 51) comprises two coupling electrodes (3a, 3b) at least one of which is capable of performing a mechanical self-oscillation with a specific resonance frequency (fl, .., fN) and/or a specific attenuation to enable an electric coupling between said coupling electrodes (3a, 3b) which depends on said specific resonance frequency (fl, .., fN) and/or specific attenuation,
- stimulating means (IG1, IG2, .., IGN) that are configured to selectively stimulate a mechanical self-oscillation of at least one of said coupling elements (2; 41; 51), and
- signal processing means (22) configured to determine at least one parameter characterizing an actual resonance frequency and/or an actual attenuation exhibited by at least one coupling element (2; 41; 51) in response to a stimulation applied by said stimulating means (IG1, IG2, .., IGN).

Fig. 1a

## Description

Field of the invention

The invention relates to a radio frequency, RF, signal generator for providing an RF signal.

The invention further relates to a method of operating an RF signal generator.

Background

Conventional electronic RF signal generators usually are based on a non-RF input signal which is upconverted to an RF range, e.g. by multiplying the input signal with a corresponding local oscillator signal, which transforms the input signal in a per se known manner to the radio frequency range depending on the frequency of the local oscillator signal employed for multiplication.

The conventional approach of providing and/or amplifying an RF signal comprises several disadvantages such as e.g. the introduction of nonlinearities and the like.

Accordingly, it is an object of the present invention to provide an improved RF signal generator as well as improved signal amplification and an improved method of operating such an RF signal generator which do not suffer from the disadvantages of prior art systems.

Summary

According to the present invention, regarding the above mentioned RF signal generator, this object is achieved by said RF signal generator comprising:

- at least two coupling elements, wherein each coupling element comprises two coupling electrodes at least one of which is capable of performing a mechanical self-oscillation with a specific resonance frequency and/or a specific attenuation to enable an electric coupling between said coupling electrodes which depends on said specific resonance frequency and/or specific attenuation,

- stimulating means that are configured to selectively stimulate a mechanical self-oscillation of at least one of said coupling elements, and

- signal processing means configured to determine at least one parameter characterizing an actual resonance frequency and/or an actual attenuation exhibited by at least one coupling element in response to a stimulation applied by said stimulating means.

As the basic idea of the invention, the RF output signal is generated by composing its frequency components generated by means of at least two coupling elements, which act as mechanical oscillators at their resonance frequency each. When excited, at least one component of each coupling element oscillates at its resonance frequency, and via the change of its coupling between the coupling electrodes during an oscillation, the corresponding frequency component can be generated by modulating an externally applied supply voltage (providing electric power). This results in an "implicit" frequency upconversion.

The employment of the self-resonance of the coupling elements in the RF signal generator according to the embodiments allow for a completely novel and disruptive approach for realization of a highly efficient RF signal generator: the RF output signal is generated by the combination of a plurality of spectral signal components which are generated by the controlled triggered self-oscillations of the coupling elements.

According to an embodiment, the coupling elements are grouped in a number of sub-arrays, wherein each sub-array is characterized by specific physical parameters such as e.g. geometrical dimension, material, suspension of their coupling electrodes, wherein the physical parameters define the self resonance at a well-defined frequency and/or attenuation. Within this embodiment, all coupling elements of the same sub-array have the same resonance frequency and/or the same attenuation, within the limits of the manufacturing tolerance.

According to a further embodiment, individual coupling elements are provided, each of which being characterized by specific physical parameters such as e.g. geometrical dimension, material, suspension of their coupling elements, wherein the physical parameters define the self resonance at a well-defined frequency and/or attenuation. Within this embodiment, all coupling elements may have an individual resonance frequency and/or attenuation, within the limits of the manufacturing tolerance.

Combinations of both approaches (sub-arrays vs. provisioning individual coupling elements) are also possible.

The concept according to the embodiments advantageously allows to overcome the currently available RF signal generator architecture, in particular by avoiding an upconversion process by means of multiplication with a local oscillator signal. Other components of conventional RF generation systems (e.g., digital-to-analog converters), which usually add errors to the RF output signal, may also advantageously be omitted by employing the RF signal generator according to the embodiments.

The concept according to the embodiments advantageously combines the benefits of a switched amplifier, namely high efficiency, digital control, wide band operation, and efficient parallel operation of fragmented frequency bands, with the benefits of the analogue amplifiers and upconverter modules, namely simplification or even avoidance of a reconstruction filter with its nonlinearities and matching losses. By means of the present embodiments, an external reconstruction filter for improving the RF output signal regarding its spectral properties can be simplified or even be completely avoided together with its related matching circuitry in a switched power amplifier.

In difference to class-S switched amplifiers, the device according to the embodiments does not involve delta-sigma or comparable modulation. It features 100% coding efficiency. Thus, it contributes to an improved energy efficiency of a transmitter apparatus comprising the inventive RF signal generator while maintaining linearity. Additionally, by increasing the number of coupling elements, the supported signal bandwidth can be large, and is in particular not limited by a digital-to-analog converter.

More specifically, since the RF signal generation according to the embodiments is based on a synthesis of the RF signal from its spectral components by means of the coupling elements, RF signals with fragmented frequency bands (i.e., signal components within the RF signal which comprise comparatively large frequency spacings of e.g. some hundred MHz up to several GHz) may be generated with a particularly high efficiency by providing and controlling coupling elements having resonance frequencies in the respective frequency ranges. E.g., a first number of coupling elements may be provided having resonance frequencies within a first RF range of e.g. 820 MHz to 860 MHz, whereas at least a second number of coupling elements may be provided having resonance frequencies within a second RF range of e.g. 2620 MHz to 2660 MHz thus offering a frequency spacing between both frequency bands of nearly 2 GHz.

Generally, any number of coupling elements having arbitrary resonance frequencies and/or attenuations may be provided as long as the signal processing means may adequately control the various coupling elements, e.g. depending on the RF output signal to be generated.

In general, each coupling element comprises at least two coupling electrodes, at least one of which is capable of performing a mechanical self-oscillation with a specific resonance frequency and/or a specific attenuation to enable an electric coupling between said coupling electrodes which depends on said specific resonance frequency and/or specific attenuation.

Stimulating means are configured to selectively stimulate a mechanical self-oscillation of at least one of said coupling elements or its coupling electrode(s) capable of said mechanical self-oscillation.

To ensure an efficient and precise RF signal generation, advantageously, signal processing means, which may also be configured to control the stimulating means, are configured to determine at least one parameter characterizing an actual resonance frequency and/or an actual attenuation exhibited by at least one coupling element in response to a stimulation applied by said stimulating means. Thus, the RF signal generator according to the embodiments advantageously offers a possibility for calibrating itself, which may e.g. be performed once after manufacturing, or preferably dynamically and/or periodically, e.g. during an ordinary operation of said RF signal generator in a target system such as an RF transceiver of a base station of a cellular communications network or the like.

As already explained above, generally, the coupling electrodes of a coupling element form opposing parts, and at least one of those parts may mechanically oscillate (i.e., vibrate) relative to the other part or each other, respectively. In a preferred embodiment, the second opposing part (second coupling electrode) may also mechanically oscillate, preferably also with the resonance frequency of its opposing counterpart, i.e., the first coupling electrode.

A distance between or an overlap of the two coupling electrodes determines the degree of coupling of the coupling element, which varies during the mechanical self-oscillation of the coupling element or its electrode(s), respectively. Typically, in a non-oscillating state (home state) of a coupling element, the coupling is comparatively low (preferably practically zero, according to an embodiment).

Further preferably, the coupling elements are designed such that said coupling electrodes keep a spatial separation even in a tight coupling state in which their coupling is at its maximum, thus reducing mechanical wear. The coupling between the coupling electrodes may typically be based on electron emission or tunnelling effect; this results in a continuous dependency of the electric coupling with the distance or degree of overlap of the electrodes of the coupling element. The coupling may further be influenced by providing a specific vacuum or low-pressure environment or ionized media around the coupling electrodes. Moreover, the coupling may also be influenced by a specific shape of the opposing sections of the coupling electrodes (needle-type, spherical, and the like).

A single coupling element, according to an embodiment, may have a maximum spatial dimension of 1 $\mu$m or less. A mobile part (e.g., electrode) of a coupling element typically may have a maximum dimension of 800 nm or less. The dimensions of a coupling element are also chosen with respect to the material from which the coupling element or its electrodes are made.

According to a further embodiment, a few hundreds or even thousands of coupling elements per sub-array may be provided in order to be able to generate an RF output signal with adequate signal power. An overall number of coupling elements may well exceed ten thousand.

Typically, according to a further embodiment, each coupling element has an individual stimulating generator means such as a coating with piezoelectric material; however, it is also possible to have a common stimulation generator means for a plurality of coupling elements.

The RF signal generator according to the embodiments can e.g. be used as part of a transmitter arrangement, e.g. in base stations of mobile communication networks, in particular mobile telephony networks. The invention may be of particular use for radio transmitters in BTS (base transceiver stations) and User terminal equipment, defense systems, consumer electronics, and Software-Defined-Radio (SDR) and Cognitive Radio (CR) applications.

According to a further preferred embodiment, said signal processing means are configured to individually determine an actual resonance frequency and/or an actual attenuation of all coupling elements which enables to precisely assess the actual operating parameters (resonance frequency, attenuation) of the coupling elements comprised within a specific RF signal generator.

According to a further preferred embodiment, said signal processing means are configured to control a generation of said RF signal depending on an actual resonance frequency and/or an actual attenuation of said at least one coupling element. Thus, manufacturing variations, which may e.g. lead to deviations from a desired resonance frequency of specific coupling elements may be accounted for. For instance, if the signal processing means according to the embodiments comprise knowledge on an actual resonance frequency of every coupling element, groups of coupling elements may be formed, wherein the specific coupling elements being member of a group all exhibit the same resonance frequency or a resonance frequency being in a frequency range associated with said group.

According to a preferred embodiment, said signal processing means are configured to determine a plurality of coupling elements which have an actual resonance frequency within a predetermined frequency range, and to define a sub-array of coupling elements associated with said predetermined frequency range from said plurality of coupling elements. By so defining sub-arrays, it can advantageously be ensured that each sub-array only comprises coupling elements which conform with the desired specific resonance frequency or resonance frequency range, respectively.

According to a further preferred embodiment, said signal processing means are configured to simultaneously stimulate at least two coupling elements of said sub-array, whereby a signal power of the generated RF signal may be increased. Preferably, all coupling elements of a specific sub-array will simultaneously be stimulated to achieve a maximum RF output signal power.

According to a further advantageous embodiment, during a manufacturing process of the RF signal generator, specifically of the coupling elements, a number of coupling elements may be produced which exceeds the nominal number of coupling elements that is required for achieving a specific RF output signal energy. After said step of manufacturing, a calibration as already explained above may be performed, whereby those coupling elements can be identified which actually comprise a resonance frequency within the desired frequency range. Usually, due to manufacturing tolerances, only a specific portion of the overall number of manufactured coupling elements will satisfy requirements regarding a specific resonance frequency or attenuation, and those identified coupling elements may be further used by the RF signal generator for RF signal generation.

According to a further embodiment, said signal processing means are configured to determine such coupling elements, an actual resonance frequency and/or an actual attenuation of which is not within a predetermined frequency range and/or attenuation range, and to omit respective coupling elements when generating said RF signal, whereby the linearity of the generated RF output signal and an overall spectral quality of the RF output signal may be increased.

According to a further embodiment, said RF generator is configured to provide an RF signal which comprises a plurality of spectral components, and wherein for each spectral component at least one coupling element, preferably a plurality of coupling elements, is provided, which comprise a resonance frequency that is associated with the respective spectral component.

According to a further embodiment, said stimulating means comprise a plurality of stimulating impulse generators, wherein groups of coupling elements, or preferably single coupling elements, are assigned to a respective stimulating impulse generator. Thus, either individual coupling elements may be stimulated in an isolated manner, or advantageously a simultaneous stimulation of several coupling elements may be effected.

According to a further preferred embodiment, the stimulating means comprise a piezoelectric element, in particular a piezoelectric coating on a coupling electrode of a coupling element, wherein said stimulating impulse generator is configured to apply a predetermined voltage to the piezoelectric element to excite an oscillation of the coupling electrode. Depending on the specific configuration of the signal processing means, it is also possible to stimulate a self oscillation of one or more coupling elements by applying a voltage signal comprising a specific pulse shape to the piezoelectric element(s) provided for stimulating the respective coupling elements. By defining specific pulse shapes for the voltage control of the stimulating generators, an even more precise generation of the desired RF output signal is enabled.

According to a further advantageous embodiment, the coupling electrodes of a coupling element comprise two opposing and/or partially overlapping sections, wherein said sections are designed to maintain a special separation even in a tight coupling state between said coupling electrodes, which advantageously reduces a mechanical wear.

A further solution to the object of the present invention is given by a method of operating radio frequency signal generator according to claim 11. The inventive method comprises the steps:

-    selectively stimulating a mechanical self-oscillation of at least one of said coupling elements by means of stimulating means, and

- determining, by means of signal processing means, at least one parameter characterizing an actual resonance frequency and/or an actual attenuation exhibited by at least one coupling element in response to said stimulation applied by said stimulating means.

According to a further embodiment, said signal processing means individually determine an actual resonance frequency and/or an actual attenuation of a plurality, or preferably of all, coupling elements, which enable a very precise control of individual coupling elements.

According to a further embodiment, said signal processing means control a generation of said RF signal depending on an actual resonance frequency and/or an actual attenuation of said at least one coupling element, which can e.g. be periodically determined according to the embodiments or once after a manufacturing process of the radio frequency signal generator.

According to a further embodiment, said signal processing means determine a plurality of coupling elements which have an actual resonance frequency within a predetermined frequency range, define a sub-array of coupling elements associated with said predetermined frequency range from said plurality of coupling elements, and simultaneously stimulate at least two coupling elements of said sub-array.

According to a further embodiment, said signal processing means determine such coupling elements, an actual resonance frequency and/or an axial attenuation of which is not within a predetermined frequency range and/or attenuation range and omit respective coupling elements when generating said RF signal.

Brief description of the figures

Further features, aspects and advantages of the present invention are given in the following detailed description with reference to the drawings in which:

Figure 1a    schematically depicts a coupling array of an RF signal generator according to an embodiment,

figure 1b    schematically depicts a single coupling element of the configuration according to figure 1a in a home state,

figure 1c    schematically depicts the coupling element of figure 1b in a deflected state of increased coupling,

figure 2    schematically depicts an RF signal generator according to a further embodiment,

figure 3    schematically depicts an embodiment of a reedshaped structure which forms a part of a coupling element according to a further embodiment,

figure 4    schematically depicts a coupling element comprising membrane shape according to a further embodiment,

figure 5    schematically depicts a coupling element comprising a torsion element and a jacket,

figure 6a    schematically depicts an RF signal generator comprising ideally shaped coupling elements according to an embodiment,

figure 6b    schematically depicts an RF signal generator comprising coupling elements as obtained by a real manufacturing process with nonvanishing manufacturing tolerances, and

figure 7    depicts a simplified flow-chart of a method according to the embodiments.

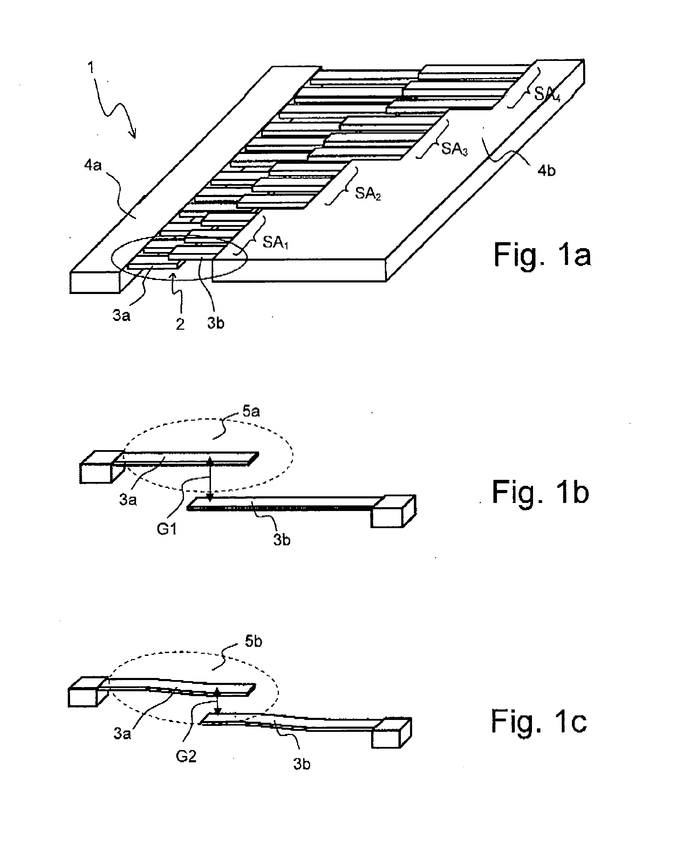

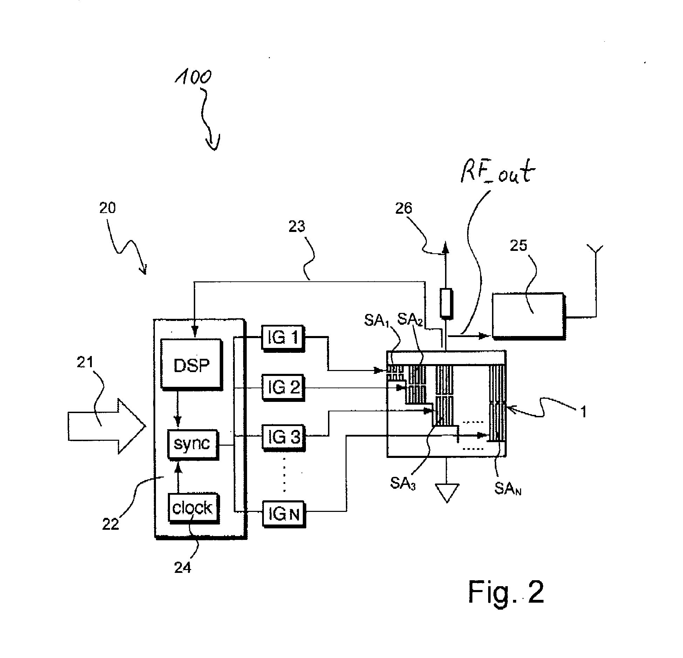

Fig. 1a illustrates in a schematic, perspective view a coupling array 1 which may e.g. be used in an RF signal generator 100 according to the embodiments, also cf. Fig. 2, for generating electric RF signals as explained in further detail below. The coupling array 1 comprises a plurality of coupling elements 2, each of which comprises two coupling electrodes 3a, 3b. Since according to the present embodiment, the coupling electrodes 3a, 3b comprise a reed-type shape, they may also be denoted as "coupling reeds". As can be seen from Fig. 1a, the coupling electrodes 3a, 3b of a coupling element 2 are arranged opposite to each other, but preferably with some overlap in the region of their free ends (see Fig. 1b and 1c for more details).

The ends of the reeds 3a, 3b facing away from the respective opposing reed 3a, 3b are attached to a suspension 4a, 4b each. Within the present embodiment, common suspensions 4a, 4b for all reeds 3a, 3b of each respective one side of the coupling array 1 are used.

All coupling elements 2 according to the embodiments are deigned such that at least one coupling electrode 3a, 3b is capable of performing a mechanical self-oscillation with a specific resonance frequency and/or a specific attenuation to enable an electric coupling between both coupling electrodes 3a, 3b of a specific coupling element 2 which depends on said specific resonance frequency and/or specific attenuation.

Within the present embodiment depicted by Fig. 1a, both coupling reeds (i.e., coupling electrodes) 3a, 3b are configured such that they may oscillate with their free ends, perpendicularly to their shortest dimension, i.e. up and down in Fig. 1a.

Further within the present embodiment depicted by Fig. 1a, the coupling elements 2 are grouped in sub-arrays SA1, .., SA4. In the schematic illustration of Fig. 1a, four sub-arrays SA1-SA4 with each sub-array SA1-SA4 having three coupling elements 2 are shown for simplicity; however in practical implementations, according to a preferred embodiment, there may be much more sub-arrays (typically a thousand or more) and/or much more coupling elements per sub-array (typically several thousands).

The actual number N of sub-arrays and the number of coupling elements 2 per sub-array inter alia depends on a required bandwidth, a required frequency resolution, a required signal output power for the RF output signal to be generated by the array 1 and the electrical characteristics of the coupling contacts.

Within each sub-array SA1-SA4, according to a preferred embodiment, the coupling elements 2 have the same physical dimensions and properties (within the manufacturing tolerances), and therefore exhibit the same resonance frequency and the same attenuation.

In the exemplary array 1 shown by Fig. 1a, the length of the reeds 3a, 3b and thus their resonance frequency increases from the first (front) sub-array SA1 to the last (rear) sub-array SA4, giving the coupling array 1 a harp-like design.

Since each sub-array (or group) of coupling elements represents a distinct resonance frequency, which according to the present embodiment is given by

$$ f = \frac{1}{2\pi} \sqrt{\frac{E}{\rho} \frac{d}{l^2}} $$

wherein E is Young's modulus, p is a specific mass of a coupling electrode, d is a thickness of the coupling electrode, 1 is a length of the coupling electrode, there is a plurality of N sub-arrays (only four of which are shown in Fig. 1a, namely SA1-SA4) to compose a desired RF output signal from its frequency components f1 to fN, wherein N is the number of discrete frequency component bins in an input signal to be converted to the RF output signal. Note that in this way, advantageously a frequency upconversion is performed inherently by the coupling elements 2, because the self oscillation frequencies of the structure 1 are centred at the RF carrier, i.e. the coupling elements are chosen such that their mechanical self oscillation frequencies are already in the required RF frequency range of the RF output signal to be generated.

Thus, instead of utilizing an upconversion process as proposed by conventional RF signal generating systems, the RF signal generator 100 (Fig. 2) according to the embodiments may employ one or more arrays 1 as depicted by Fig. 1a. For obtaining an RF output signal, instead of upconverting any input signal, the coupling elements 2 are rather only required to be excited to perform a mechanical self-oscillation, whereby an electric RF output signal is generated as explained in more detail below.

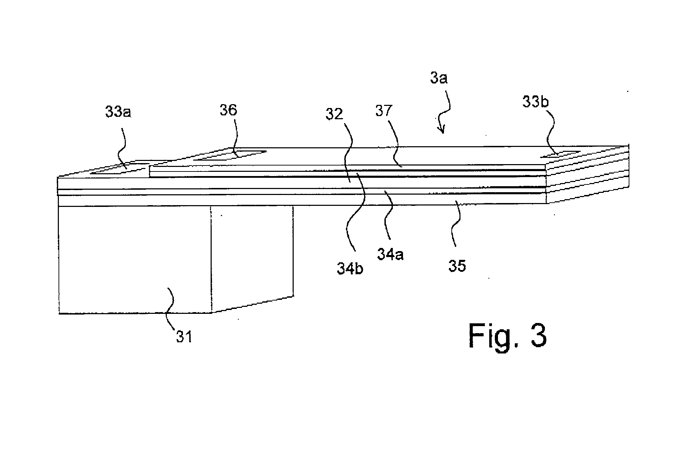

For instance, a coupling element 2 (Fig. 1a) may be triggered to a self-oscillation by an ultra-short electrical impulse, which is converted into a mechanical stimulating impulse e.g. through piezoelectric conversion, which may be enabled by an appropriate piezoelectric coating of the contact reeds (see Fig. 3). Other forms of mechanical stimulation to generate a self-oscillation of the coupling elements 2 may also be employed.

The oscillation of the coupling electrodes (i.e., reeds) 3a, 3b of a coupling element 2 (compare Fig. 1, oval marking) is illustrated in more detail in Figs. 1b and 1c. In Fig. 1b, a home state (undeflected state) of the reeds 3a, 3b is shown. In the example shown, the left reed 3a is connected to a negative potential, and the right reed 3b is connected to a positive potential of a direct current, DC, (i.e., constant) voltage supply (not shown). In the undeflected state, the reeds 3a, 3b are separated by a relatively large gap G1, and accordingly, the electric field strength between the reeds 3a, 3b is relatively low. As a result, there is only a low (and practically negligible) electron emission current form reed 3a to reed 3b. In Fig. 1b, there is also indicated an area 5a around the reed 3a in which significant electron tunnelling to an opposing (neighboring) reed may occur at the given voltage. Since the reed 3b as depicted by Fig. 1b is outside the area 5a, there is also no significant tunnelling current from reed 3a to reed 3b. In summary, in the undeflected state of Fig. 1b, there is only a low, i.e. practically vanishing, electric coupling of the reeds 3a, 3b.

Fig. 1c, in contrast, shows the reeds 3a, 3b in a deflected state, wherein the reeds 3a, 3b have approached each other with their free ends (the free end of reed 3a is bent downwards, and the free end of reed 3b is bent upwards); this deflected state is e.g. attained periodically during each self-oscillation of the reeds (note that the reeds 3a, 3b here oscillate at the same frequency and at a fixed phase shift of 180°). The remaining gap G2 is relatively small as compared to G1 (Fig. 1b), and for preferred embodiments typically on the order of only a few nanometers. In accordance with the relatively small gap G2, the electric field strength between the reeds 3a, 3b has increased. As a result, there is an increased electron emission current from reed 3a to reed 3b, as compared to the undeflected state of Fig. 1b. In order to increase the electron emission current, the reeds 3a and/or 3b may be made from or coated with a material of low or negative electron affinity (e.g. diamond). A particular shape of the opposing electrodes' ends (i.e., needle-type or spherical) may also further influence electron emission properties.

Further, the area 5b, which surrounds reed 3a and in which significant electron tunneling may occur from reed 3a to an opposing reed, has bent downward towards to the opposing reed 3b in the course of the self-oscillation, such that the free end of reed 3b is now within the area 5b; therefore a significant tunnelling current will flow from reed 3a to reed 3b. In Summary, in the deflected state of Fig. 1c, there is an increased electrical coupling (i.e., a good electrical conductivity) between the reeds 3a and 3b, and thus a nonvanishing electric current will flow between the electrodes 3a, 3b. Since the electrical coupling, however, oscillates between the states depicted by Fig. 1b, 1c, due to the self-oscillation, the current flowing between the electrodes 3a, 3b is advantageously also modulated with the frequency and attenuation pattern of the self-oscillation of the specific coupling element. Thus, an alternating current in the RF frequency range is obtained from each coupling element 2 that is excited for a self-oscillation if a (preferably DC) supply voltage is connected to the opposing coupling electrodes 3a, 3b.

However, the principle according to the embodiments is not limited to a DC voltage supply for the opposing coupling electrodes 3a, 3b of a coupling element; an AC voltage supply may also be used which offers a further degree for shaping the spectral properties of generated RF output signals.

Moreover, although the configuration depicted by Fig. 1b, 1c represents a particularly preferred embodiment of a coupling element 2, the coupling electrodes 3a, 3b need not be symmetrical necessarily. It is rather also possible to provide a first coupling electrode 3a with self-resonant properties as explained above and to provide a second, i.e. opposing, coupling electrode 3b which is not required to have self-resonant properties in the same frequency range at all. E.g., it is also possible to provide a second coupling electrode 3b which is not configured for self-oscillation at all (e.g. by providing a sufficient attenuation characteristic).

Fig. 2 shows a schematic block diagram of an RF signal generator 100 according to the embodiments. The RF signal generator 100 comprises a signal processing stage 20 which comprises a signal processing unit 22. The signal processing unit 22 receives input signal information 21 which characterizes spectral components (i.e. signal frequencies fl, .., fN) and/or respective amplitudes and/or respective phases of an RF output signal RF_out which is to be generated by the device 100.

Alternatively or additionally, it is also possible to have an analyzing unit (not shown) integrated in the signal processing unit 22, wherein the analyzing unit identifies spectral components of an RF input signal (not shown) to be amplified by the device 100. This RF input signal may e.g. be directly fed to the signal processing unit.

Based on the input signal information 21, the signal processing unit 22 calculates a pulse form and/or timing for stimulating pulses which excite respective self-oscillations of specific coupling elements 2 (Fig. 1a) of the array 1 of the RF signal generator 100.

In the example shown by Fig. 2, this information is sent to stimulating impulse generators IG1, .., IGN. According to the present embodiment, one stimulating impulse generator IG1, .., IGN is provided for each sub-array SA1, .., SAN of the coupling array 1. The stimulating impulse generators, create stimulating pulses for their respective sub-array each, based on the pulse form and timing information from the signal processing unit 22.

In response to the stimulating pulses, the coupling elements 2 (Fig. 1a) of all excited sub-arrays perform a self-oscillation thus generating respective RF currents through the array 1, which are added implicitly at one common terminal of the array 1 that is connected to a DC voltage supply 26 via a resistor. The added RF currents represent the RF output signal RF_out generated according to the embodiments.

The amplitude of the stimulating pulse determines the power of the spectral component and the timing determines its phasing. The calculation of the pulse form and timing is based on the spectral input information 21 which is e.g. provided on baseband level as explained above, and/or a fed back sample (see feedback loop 23) of the so generated RF output signal RF_out, and a reference clock 24. The resonance frequencies of the coupling elements 2 within the sub-arrays SA1, .., SAN are fixed and have been designed to correspond to desired frequency components for the RF output signal RF_out to be generated. In the example shown by Fig. 2, the RF output signal RF_out is directly fed into an antenna network 25, i.e. for broadcast via the air interface enabled by the antenna network 25.

Alternative or additionally, the feedback loop 23 may also pick up a signal portion at an output of the antenna network 25, which enables to include the antenna network 25 into a linearization process employing said feedback loop 23.

The supply voltage applied between the supply input 26 and a further reference potential such as analog ground potential, here a direct current (DC) supply voltage, effects a current through the coupling array 1, which depends on the electrical coupling within the sub-arrays SA1-SAN of the coupling elements 2 (Fig. 1a) incorporated therein. Presently, the sub-arrays SA1-SAN are electrically connected in parallel.

As an example, an inventive RF signal generator 100 according to a preferred embodiment may provide a frequency resolution in equal steps of between 1 kHz and 50 kHz, with a typical width of a resolved frequency interval of between 1 MHz and 100 MHz. The center frequency of the RF output signal RF_out to be generated may e.g. range between 500 MHz and 10 GHz. For example, with a frequency resolution of 50 kHz and a width of MHz, the coupling array 1 comprises about 1000 sub-arrays, i.e. N=1000.

Fig. 3 shows in a schematic, perspective view a layer structure (coating structure) of a reed 3a according to an embodiment. On a coupler contact 31 (which may be part of the suspension 4a in Fig. 1a), the reed 3a is mounted at one (left) end; the other (right) end extends freely away from the coupler contact 31.

The base structures of the coupling electrode 3a are a layer (or coating) supporting electron emission 35 ("emission layer") and a piezoelectric (piezoactive) layer (or coating) 32.

The emission layer 35 is directly attached to the coupler contact 31 to electrically connect the emission layer 35 to a voltage supply (not shown) and faces the other reed (compare Fig. 1b for example, reed 3b). The emission layer 35 and the piezoactive layer 32 are separated by an insulating layer 34a, such as an oxide layer. On top of the piezoactive layer 32, there is another insulating layer 34b and a metallization 37.

The piezoactive layer 32 may be electrically contacted at its left (exposed) end via a first piezo contact 33a, and at its right (covered) end via a second (window) contact 33b reaching through the upper insulating layer 34b. The second (window) contact 33b is electrically connected via the metallization 37 to a metallization contact 36 in the region of the coupler contact 31 such that the areas of immediate connection to an external piezo voltage supply, namely the first contact 33a and the metallization contact 36, are well reachable and are not exposed to deflection during a reed oscillation thus not affecting the self-oscillation.

By applying a voltage across the piezoelectric coating 32, the piezoelectric coating 32 may e.g. be contracted whereas the emission layer 35 remains at its original length, resulting in an upward-bending of the reed 3a at its free right end. After the voltage application has ended, the reed 3a will oscillate at its resonance frequency, causing a coupling varying with the resonance frequency.

Note that the reed 3a may comprise an additional layer, in particular in order to deposit both the emission layer and the piezoactive layer as coatings on the additional layer, and/or to better control the mechanical properties (such as the resonance frequency via a dominant specific mass) of the reed 3a. It is also noted that piezoelectric multilayer structures may be applied instead of a single piezoactive layer 32. Note that the resonance frequency of a coupling element and here the coupling electrode 3a, in accordance with the invention, is typically in the GHz range.

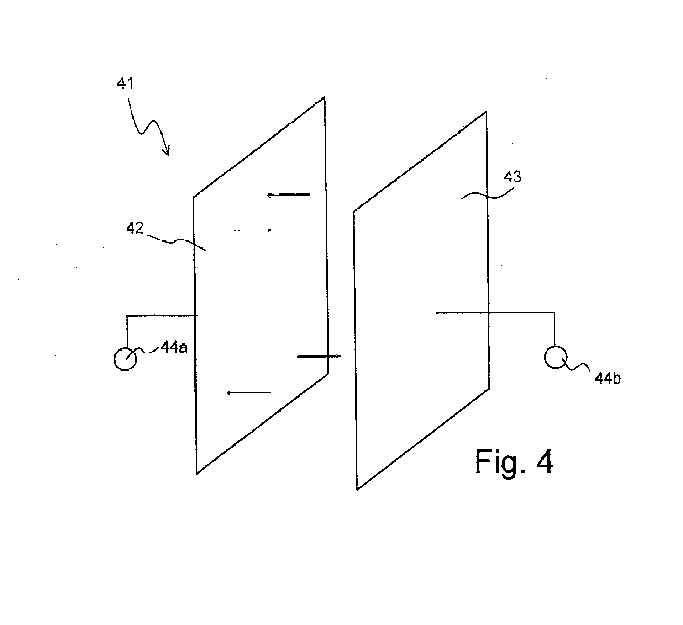

Fig. 4 shows a simple membrane-based coupling element 41. The coupling element 41 comprises a membrane 42 arranged opposite to a stiff coupling surface 43 (note that alternatively the coupling surface 43 may be realized on another movable membrane). As such, the components 42, 43 represent coupling electrodes in the sense of the present invention. The membrane 42 may oscillate at its resonance relative to the coupling surface 43, e.g. in the way indicated by the arrows. As a result, electrical current flowing through the coupling element 41 (see electrical contacts 44a, 44b) will oscillate with a frequency corresponding to the resonance frequency of the membrane 42. In order to initiate the self oscillation, the membrane 42 has a piezoelectric coating (not shown).

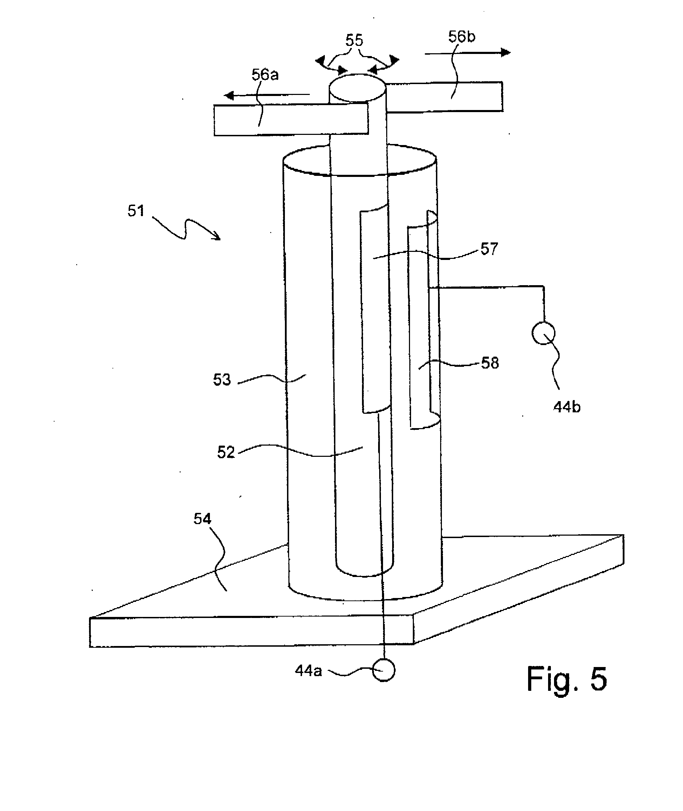

Fig. 5 illustrates a further coupling element 51, based on a torsion unit 52 and a jacket 53. On a fixed mounting 54, the torsion unit 52 (here of a rod-type shape) and the jacket 53, which surrounds the torsion unit 52, are fixed with their lower ends. The torsion unit 52, or more specifically its upper end, may be twisted (elastically rotated) around its vertical axis (see arrows 55); upon a deflection, the torsion unit 52 will exhibit a torsion oscillation at its resonance frequency. A torsion oscillation may be triggered by means of a two-part torsion impulsion (drive) 56a, 56b.

On the outer surface of the torsion unit 52, there is a first coupling surface 57, which covers about one third of the torsion unit's circumference. Further, on the inner surface of the jacket 53, there is a second coupling surface 58, covering about one tenth of the inner surface's circumference. The first coupling surface 57 and the second coupling surface 58 have about the same area size here. As such, the components 57, 58 represent coupling electrodes in the sense of the present invention.

The coupling surfaces 57, 58 are connected to a combined (preferably DC) power supply and an RF signal output (see contacts 44a, 44b). During an oscillation, the two coupling surfaces 57, 58 vary their overlap (and distance), and thus the coupling varies with the resonance frequency of the torsion oscillation, wherein an electric RF signal having a frequency component of the self-oscillation of the torsion unit 52 is obtained.

The proposed embodiments realize a highly efficient and highly linear RF signal generation which advantageously does not require a D/A converter or an upconversion module any more, in contrast to state of-the-art RF power signal generator or - transmitter architectures. Moreover, a reconstruction filter is not required with the inventive RF signal generator 100. A large signal bandwidth of the RF output signal RF_out (Fig. 2) can more easily be supported by simply increasing the number of coupling elements or sub-arrays operating at the respective frequencies. Additionally, fragmented transceiver architecture (parallel operation of fragmented frequency bands) becomes feasible, without decreasing efficiency, as this is true for conventional wideband amplifiers, e.g. based on Class-AB operation.

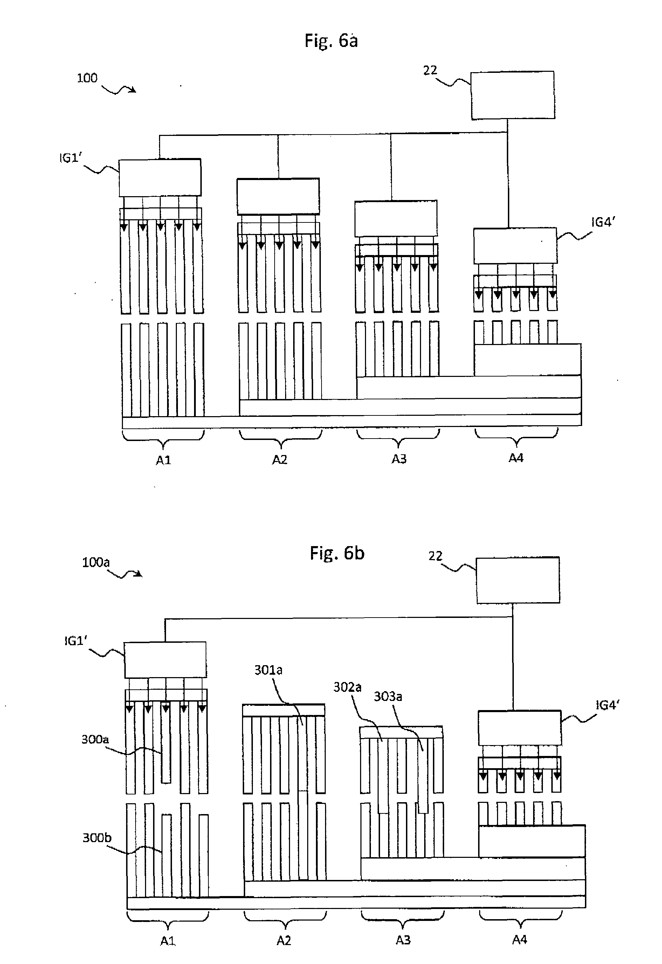

Figure 6a depicts a further RF signal generator 100 according to the embodiments. The RF signal generator 100 depicted by Figure 6a comprises four arrays A1, ..., A4 of coupling elements all of which are assumed to have an ideal shape and thus exactly exhibit the desired resonance frequency each. For instance, the coupling elements of array A1 have the lowest resonance frequency because they have the largest geometrical dimensions and thus the largest oscillating mass, whereas the coupling elements of the fourth coupling array A4 comprise the highest resonance frequency due to their comparatively short spatial dimensions.

Impulse generators IG1', ..., IG4' are also provided, which are controlled by the signal processing means 22 of the RF signal generator 100 as already explained above.

As symbolized by arrows pointing from the respective stimulating generators IG1', ..., IG4' to single coupling elements or coupling electrodes thereof, according to the present and particularly preferred embodiment, each coupling element depicted within Figure 6a can individually be stimulated for self-oscillation by the respective stimulating generator.

Since Figure 6a depicts an ideal configuration, which in reality cannot be obtained due to manufacturing tolerances, the coupling elements of each subarray A1, ..., A4 have an actual resonance frequency which is identical to the respective desired resonance frequency.

In contrast to the ideal system of Figure 6a, Figure 6b depicts an RF signal generator 100a the coupling elements of which are affected by manufacturing tolerances, thus representing a real system. For the sake of clarity, only the stimulating generators IG1', IG4' are depicted by Figure 6b.

For example, a first coupling electrode 300a of a third coupling element of the array A1 is shorter than its neighbour coupling electrodes, and thus the coupling electrode 300a comprises a resonance frequency which is too high as compared to its neighbouring coupling electrodes of the subarray A1. The same holds true for the second electrode 300b of the respective coupling element.

Within the second subarray A2, a further coupling electrode 301a is substantially larger than its neighbouring electrodes, which leads to the effect that said coupling electrode 301a has a lower resonance frequency than its neighbouring coupling electrodes of the same array A2.

Moreover, further similar deviations from an ideal state of the coupling electrodes 302a, 303a of the third array A3 are depicted by figure 6b.

As an exception, the coupling elements of the fourth array A4 basically exhibit the desired resonance frequency and as such are comparable to the ideal configuration of Figure 6a.

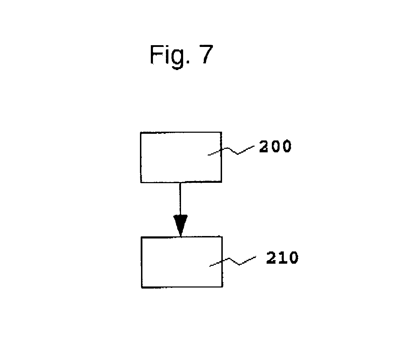

According to a particularly preferred embodiment, in a first method step 200, cf. the flow-chart of Fig. 7, the signal processing means 22 (Fig. 6b) stimulate all coupling elements of the various arrays A1, ..., A4 of Figure 6b to determine an actual resonance frequency of the respective coupling elements. During this process, the signal processing means 22 will thus detect that coupling elements 300a, 300b, 301a, 302a, 303a do not exhibit the desired properties regarding resonance frequency. The same principle of detection of deviations may also be applied regarding the attenuation of the coupling elements, of course.

For optimum precision, within step 200, each single coupling element of the RF signal generator 100a is stimulated individually, which has the effect that the generated RF output signal RF_out (Fig. 2) basically solely depends on the coupling element currently under test. Thus, by analyzing the RF output signal RF_out so obtained, the signal processing means 22 may accurately determine whether the individual coupling element currently under test is operating within predetermined parameter ranges (regarding resonance frequency and/or attenuation) or whether it is defective in that it exceeds the predetermined parameter ranges.

After assessing the actual resonance frequency of all coupling elements within step 200 (Fig. 7), the signal processing means 22 preferably store the obtained information on the actual resonance frequencies of the various coupling elements in internal storage means (not shown) for future use.

In the next step 210, when generating an RF output signal by stimulating the coupling elements of subarray A1, which are associated with a first specific spectral component of the desired RF signal, the signal processing means 22 will only control the first, the second, the fourth and the fifth coupling element of subarray A1 thus omitting the third coupling element comprising the defective electrodes 300a, 300b, in the course of generating the RF output signal. This advantageously avoids generating too high signal frequencies, which would be the case when also stimulating the coupling element with the defective electrodes 300a, 300b. Although the fifth coupling element of subarray A1 does not comprise an ideal form and thus resonance frequency, either, however, its deviation from the desired resonance frequency is comparatively small, i.e. smaller than that of the third coupling element, so that it can be employed for RF signal generation within the desired tolerances.

Thus, according to a preferred embodiment, the signal processing means 22 may rather - at best - activate the electrodes 300a, 300b in such cases, where typically coupling elements of the second subarray A2 would be activated, because, due to their manufacturing variations, the resonance frequency of the coupling element 300a, 300b is within the range of the desired resonance frequency for the coupling elements which are associated with the second subarray A2.

Likewise, the coupling elements 302a, 303a comprise a to low resonance frequency as compared to the further coupling elements of the subarray A3, which means that the signal processing means 22 could stimulate the coupling elements 302a, 303a in such cases, where frequency components are to be generated which comprise a lower frequency than emitted by first, third and fifth coupling elements of the subarray A3. For instance, the coupling elements 302a, 303a may be employed when generating frequencies which typically would be emitted by coupling elements of the first subarray A2.

Thus, by individually assessing the actual resonance frequency of all coupling elements, the signal processing means 22 can advantageously re-order the various coupling elements regarding their actual resonance frequency. As a result, the signal processing means 22 may advantageously determine only such coupling elements for stimulation which have the corresponding desired actual resonance frequency.

The afore-mentioned embodiments enable an advantageous calibration process of the coupling elements of the RF signal generator 100a which effects a particularly precise RF signal generation.

For instance, the calibration process explained above with reference to Fig. 7 may be performed after a manufacturing process of the device 100a. Alternatively or in addition, the calibration process may also be performed during an ordinary operation, i.e. if the signal generator 100a is integrated in a target system such as a transceiver module of a base station of a cellular communications network or the like. When periodically performing the inventive calibration process 200, 210, a temperature compensation and a compensation of wear effects which might also lead to a shift of the resonance frequency of specific coupling elements (or their coupling electrodes 3a, 3b, respectively) over time may be addressed. According to a particularly advantageous variant, a periodical execution of the inventive calibration process is performed during low-load situations, e.g. during night time, where the desired RF output signal energy is usually low as compared to day time. During night time, different groups of coupling elements could be controlled to perform a calibration process periodically, while other (groups of) coupling elements are controlled for performing an ordinary RF signal generation.

Alternatively or in addition, in low-load phases where the required RF output signal energy is lower than the maximum possible signal energy, different groups of coupling elements may be utilized to generate the desired RF output signal, and the signal quality of a so obtained RF output signal may be assessed. If a specific group exhibits a particularly poor signal quality, e.g. regarding spectral shape, it may be concluded that one or more coupling elements which are associated with the currently used group of coupling elements comprise substantial deviations from their desired operating parameters. By altering the scheme according to which coupling elements are associated with a specific group to be used next for signal generation, defective coupling elements may be identified in an iterative process. A specific advantage of this variant is the fact that a regular RF signal generation, is not required to be interrupted for identifying defective coupling elements.

According to a further preferred embodiment, the signal processing means 22 (Fig. 2, 6b) are configured to determine a plurality of coupling elements which have an actual resonance frequency within a predetermined frequency range, and to define a sub-array or group of coupling elements, respectively, which is associated with said predetermined frequency range from said plurality of coupling elements. Insofar, the sub-array or group of coupling elements defined according to the present embodiment, i.e. as referred to in the preceding sentence, does not necessarily comprise all coupling elements of a specific resonance frequency. Such defined group may thus also be referred to as "virtual subarray". By so defining (virtual) sub-arrays, it can advantageously be ensured that each sub-array only comprises coupling elements which conform with the desired specific resonance frequency or resonance frequency range, respectively. I.e., in contrast to the subarrays A1, .., A4 of Fig. 6b which are defined by construction of the coupling array, the embodiments may also provide for definition of "virtual" arrays or sub-arrays which only comprise coupling elements which have an actual resonance frequency within a predetermined frequency range, as determined by the method according to the embodiments. In contrast to the constructive subarrays A1, .., A4, the virtual arrays defined depending on the individual assessment of actual resonance frequencies of single or a small number of coupling elements, truly only comprise coupling elements having a desired resonance frequency. Thus, by regrouping the constructed subarrays A1, .., A4 to virtual subarrays according to the embodiments, an improved spectral quality of the RF output signal RF_out (Fig. 2) may be achieved. The steps of determining and defining virtual subarrays may preferably be performed dynamically according to a further embodiment.

According to a further preferred embodiment, said signal processing means 22 are configured to simultaneously stimulate at least two coupling elements of a sub-array, whereby a signal power of the generated RF signal RF_out may be increased. Preferably, all coupling elements of a specific (constructive or virtual) sub-array will simultaneously be stimulated to achieve a maximum RF output signal power.

According to a further advantageous embodiment, during a manufacturing process of the RF signal generator 100, 100a, specifically of the coupling elements 2, a number of coupling elements may be produced which exceeds the nominal number of coupling elements that is required for achieving a specific RF output signal energy. After said step of manufacturing, a calibration 200, 210 (Fig. 7) as already explained above may be performed, whereby those coupling elements can be identified which actually comprise a resonance frequency within the desired frequency range. Usually, due to manufacturing tolerances, only a specific portion of the overall number of manufactured coupling elements will satisfy requirements regarding a specific resonance frequency or attenuation, cf. Fig. 6b, and those identified coupling elements may be further used by the RF signal generator for RF signal generation.

According to a further embodiment, the signal processing means 22 are configured to determine such coupling elements, an actual resonance frequency and/or an actual attenuation of which is not within a predetermined frequency range and/or attenuation range, and to omit respective coupling elements when generating said RF signal, whereby the linearity of the generated RF output signal and an overall spectral quality of the RF output signal may be increased.

According to a further embodiment, the RF generator 100, 100a is configured to provide an RF signal RF_out which comprises a plurality of spectral components, and wherein for each spectral component at least one coupling element 2, preferably a plurality of coupling elements, is provided, which comprise a resonance frequency that is associated with the respective spectral component.

According to a further embodiment, the stimulating means comprise a plurality of stimulating impulse generators IG1, .. , IG1', .., IG4', wherein groups of coupling elements, or preferably single coupling elements, are assigned to a respective stimulating impulse generator. Thus, either individual coupling elements may be stimulated in an isolated manner, or advantageously a simultaneous stimulation of several coupling elements may be effected.

Instead of providing constructive sub-arrays SA1, SA2, .. (Fig. 1a) of coupling elements which already imply a target-frequency related spatial grouping of coupling elements, during manufacturing a plurality of coupling elements 2 may be provided for each desired spectral component of the RF output signal RF_out to be generated, wherein a strict target-frequency related spatial grouping is not required. It may rather be sufficient to provide a sufficiently large number of coupling elements 2 of each required resonance frequency, all of which may advantageously be individually stimulated. After manufacturing, the inventive calibration may be performed, and only then virtual arrays or groups of coupling elements may be formed according to their actual resonance frequencies as determined by calibration. This process may also be repeated during a normal operation of the RF signal generator which advantageously enables to dynamically redefine the virtual arrays of coupling elements, i.e. to compensate temperature-based or wear effects, Thus it is guaranteed that a virtual array always comprises only such coupling elements which have an actual resonance frequency, within the desired frequency range, namely the frequency range associated with their virtual array.

The aforedescribed embodiments of the RF signal generator and the method of operating such RF signal generator are not limited to coupling elements as depicted by Fig. 1a. They may rather also be applied to coupling elements of the types as depicted by Fig. 3 to 5 or any other type of coupling element which implements the explained functionality.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, a11 examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

**Claims**

1. Radio frequency, RF, signal generator (100), for providing an RF signal (RF_out) comprising:

   - at least two coupling elements (2; 41; 51), wherein each coupling element (2; 41; 51) comprises two coupling electrodes (3a, 3b) at least one of which is capable of performing a mechanical self-oscillation with a specific resonance frequency and/or a specific attenuation to enable an electric coupling between said coupling electrodes (3a, 3b) which depends on said specific resonance frequency and/or specific attenuation,
   - stimulating means (IG1, IG2, .., IGN) that are configured to selectively stimulate a mechanical self-oscillation of at least one of said coupling elements (2; 41; 51), and
   - signal processing means (22) configured to determine at least one parameter characterizing an actual resonance frequency and/or an actual attenuation exhibited by at least one coupling element (2; 41; 51) in response to a stimulation applied by said stimulating means (IG1, IG2, .., IGN).

2. RF signal generator (100) according to claim 1, wherein said signal processing means (22) are configured to individually determine an actual resonance frequency and/or an actual attenuation of a11 coupling elements (2; 41; 51).

3. RF signal generator (100) according to one of the preceding claims, wherein said signal processing means (22) are configured to control a generation of said RF signal (RF_out) depending on an actual resonance frequency and/or an actual attenuation of said at least one coupling element (2; 41; 51).

4. RF signal generator (100) according to one of the preceding claims, wherein said signal processing means (22) are configured to determine a plurality of coupling elements (2; 41; 51) which have an actual resonance frequency within a predetermined frequency range, and to define a sub-array (SA$_1$, .., SA$_N$) of coupling elements (2; 41; 51) associated with said predetermined frequency range from said plurality of coupling elements (2; 41; 51).

5. RF signal generator (100) according to claim 4, wherein said signal processing means (22) are configured to simultaneously stimulate at least two coupling elements (2; 41; 51) of said sub-array.

6. RF signal generator (100) according to one of the preceding claims, wherein said signal processing means (22) are configured to determine such coupling elements (2; 41; 51), an actual resonance frequency and/or an actual attenuation of which is not within a predetermined frequency range and/or attenuation range, and to omit respective coupling elements when generating said RF signal (RF_out).

7. RF signal generator (100) according to one of the preceding claims, wherein said RF generator (100) is configured to provide an RF signal (RF_out) which comprises a plurality of spectral components, and wherein for each spectral component at least one coupling element (2; 41; 51), preferably a plurality of coupling elements (2; 41; 51), is provided, which comprise a resonance frequency that is associated with the respective spectral component.

8. RF signal generator (100) according to one of the preceding claims, wherein said stimulating means (IC1, IG2, .., IGN) comprise a plurality of stimulating impulse generators (IG1, .., IGN), wherein groups of coupling elements (2; 41; 51), or preferably single coupling elements (2; 41; 51), are assigned to a respective stimulating impulse generator (IG1, .., IGN).

9. RF signal generator (100) according to one of the preceding claims, wherein the stimulating means comprise a piezoelectric element, in particular a piezoelectric coating (32) on a coupling electrode (3a, 3b) of a coupling element (2; 41; 51), and wherein said stimulating impulse generator (IG1, .., IGN) is configured to apply a predetermined voltage to said piezoelectric element.

10. RF signal generator (100) according to one of the preceding claims, wherein the coupling electrodes (3a, 3b) of a coupling element (2; 41; 51) comprise two opposing and/or partially overlapping sections, wherein said sections are designed to maintain a spatial separation even in a tight coupling state between said coupling electrodes (3a, 3b).

11. Method of operating a Radio frequency, RF, signal generator (100), for providing an RF signal (RF_out), said RF generator (100) comprising at least two coupling elements (2; 41; 51), wherein each coupling element (2; 41; 51) comprises two coupling electrodes (3a, 3b) at least one of which is capable of performing a mechanical self-oscillation with a specific resonance frequency (fl, .., fN) and/or a specific attenuation to enable an electric coupling between said coupling electrodes (3a, 3b) which depends on said specific resonance frequency (fl, .., fN) and/or specific attenuation, said method comprising the steps:

- selectively stimulating (200) a mechanical self-oscillation of at least one of said coupling elements (2; 41; 51) by means of stimulating means (IG1, IG2, .., IGN), and
- determining (210), by means of signal processing means (22), at least one parameter characterizing an actual resonance frequency and/or an actual attenuation exhibited by at least one coupling element (2; 41; 51) in response to said stimulation applied by said stimulating means (IG1, IG2, .., IGN).

12. Method according to claim 11, wherein said signal processing means (22) individually determine an actual resonance frequency and/or an actual attenuation of a plurality of, or preferably of all, coupling elements (2; 41; 51).

13. Method according to one of the claims 11 to 12, wherein said signal processing means (22) control a generation of said RF signal (RF_out) depending on an actual resonance frequency and/or an actual attenuation of said at least one coupling element (2; 41; 51).

14. Method according to one of the claims 11 to 13, wherein said signal processing means (22) determine a plurality of coupling elements (2; 41; 51) which have an actual resonance frequency within a predetermined frequency range, define a sub-array (SA$_1$, .., SA$_N$) of coupling elements (2; 41; 51) associated with said predetermined frequency range from said plurality of coupling elements (2; 41; 51), and simultaneously stimulate at least two coupling elements (2; 41; 51) of said sub-array.

15. Method according to one of the claims 11 to 14, wherein said signal processing means (22) determine such coupling elements (2; 41; 51), an actual resonance frequency and/or an actual attenuation of which is not within a predetermined frequency range and/or attenuation range and omit respective coupling elements when generating said RF signal (RF_out).

**Amended claims in accordance with Rule 137(2) EPC.**

1. Radio frequency, RF, signal generator (100), for providing an RF signal (RF_out) comprising:

- at least two coupling elements (2; 41; 51), wherein each coupling element (2; 41; 51) comprises two coupling electrodes (3a, 3b) at least one of which is capable of performing a mechanical self-oscillation with a specific resonance frequency and/or a specific attenuation, wherein said coupling electrodes (3a, 3b) enable an electric coupling between said coupling electrodes (3a, 3b) which depends on said specific resonance frequency and/or specific attenuation,
- stimulating means (IG1, IG2, .., IGN) that are configured to selectively stimulate a mechanical self-oscillation of at least one of said coupling elements (2; 41; 51), and
- signal processing means (22) configured to determine at least one parameter characterizing an actual resonance frequency and/or an actual attenuation exhibited by at least one coupling element (2; 41; 51) in response to a stimulation applied by said stimulating means (IG1, IG2, .., IGN).

**2.** RF signal generator (100) according to claim 1, wherein said signal processing means (22) are configured to individually determine an actual resonance frequency and/or an actual attenuation of all coupling elements (2; 41; 51).

**3.** RF signal generator (100) according to one of the preceding claims, wherein said signal processing means (22) are configured to control a generation of said RF signal (RF_out) depending on an actual resonance frequency and/or an actual attenuation of said at least one coupling element (2; 41; 51).

**4.** RF signal generator (100) according to one of the preceding claims, wherein said signal processing means (22) are configured to determine a plurality of coupling elements (2; 41; 51) which have an actual resonance frequency within a predetermined frequency range, and to define a sub-array ($SA_1$, .., $SA_N$) of coupling elements (2; 41; 51) associated with said predetermined frequency range from said plurality of coupling elements (2; 41; 51).

**5.** RF signal generator (100) according to claim 4, wherein said signal processing means (22) are configured to simultaneously stimulate at least two coupling elements (2; 41; 51) of said sub-array.

**6.** RF signal generator (100) according to one of the preceding claims, wherein said signal processing means (22) are configured to determine such coupling elements (2; 41; 51), an actual resonance frequency and/or an actual attenuation of which is not within a predetermined frequency range and/or attenuation range, and to omit respective coupling elements when generating said RF signal (RF_out).

**7.** RF signal generator (100) according to one of the preceding claims, wherein said RF generator (100) is configured to provide an RF signal (RF_out) which comprises a plurality of spectral components, and wherein for each spectral component at least one coupling element (2; 41; 51), preferably a plurality of coupling elements (2; 41; 51), is provided, which comprise a resonance frequency that is associated with the respective spectral component.

**8.** RF signal generator (100) according to one of the preceding claims, wherein said stimulating means (IG1, IG2, .., IGN) comprise a plurality of stimulating impulse generators (IG1, .., IGN), wherein groups of coupling elements (2; 41; 51), or preferably single coupling elements (2; 41; 51), are assigned to a respective stimulating impulse generator (IG1, .., IGN).

**9.** RF signal generator (100) according to one of the preceding claims, wherein the stimulating means comprise a piezoelectric element, in particular a piezoelectric coating (32) on a coupling electrode (3a, 3b) of a coupling element (2; 41; 51), and wherein said stimulating impulse generator (IG1, .., IGN) is configured to apply a predetermined voltage to said piezoelectric element.

**10.** RF signal generator (100) according to one of the preceding claims, wherein the coupling electrodes (3a, 3b) of a coupling element (2; 41; 51) comprise two opposing and/or partially overlapping sections, wherein said sections are designed to maintain a spatial separation even in a tight coupling state between said coupling electrodes (3a, 3b).

**11.** Method of operating a Radio frequency, RF, signal generator (100), for providing an RF signal (RF_out), said RF generator (100) comprising at least two coupling elements (2; 41; 51), wherein each coupling element (2; 41; 51) comprises two coupling electrodes (3a, 3b) at least one of which is capable of performing a mechanical self-oscillation with a specific resonance frequency (fl, .., fN) and/or a specific attenuation, wherein said coupling electrodes (3a, 3b) enable an electric coupling between said coupling electrodes (3a, 3b) which depends on said specific resonance frequency (fl, .., fN) and/or specific attenuation, said method comprising the steps:

- selectively stimulating (200) a mechanical self-oscillation of at least one of said coupling elements (2; 41; 51) by means of stimulating means (IG1, IG2, .., IGN), and
- determining (210), by means of signal processing means (22), at least one parameter characterizing an actual resonance frequency and/or an actual attenuation exhibited by at least one coupling element (2; 41; 51) in response to said stimulation applied by said stimulating means (IG1, IG2, .., IGN).

**12.** Method according to claim 11, wherein said signal processing means (22) individually determine an actual resonance frequency and/or an actual attenuation of a plurality of, or preferably of all, coupling elements (2; 41; 51).

**13.** Method according to one of the claims 11 to 12, wherein said signal processing means (22) control a generation of said RF signal (RF_out) depending on an actual resonance frequency and/or an actual attenuation of said at least one coupling element (2; 41; 51).

**14.** Method according to one of the claims 11 to 13, wherein said signal processing means (22) determine a plurality of coupling elements (2; 41; 51) which have an actual resonance frequency within a predetermined frequency range, define a sub-array $(SA_1, .., SA_N)$ of coupling elements (2; 41; 51) associated with said predetermined frequency range from said plurality of coupling elements (2; 41; 51), and simultaneously stimulate at least two coupling elements (2; 41; 51) of said sub-array.

**15.** Method according to one of the claims 11 to 14, wherein said signal processing means (22) determine such coupling elements (2; 41; 51), an actual resonance frequency and/or an actual attenuation of which is not within a predetermined frequency range and/or attenuation range and omit respective coupling elements when generating said RF signal (RF_out).

Fig. 1a

Fig. 1b

Fig. 1c

100

RF_out

20

23

26

25

21

DSP

IG 1

SA₁ SA₂

sync

IG 2

IG 3

1

22

clock

IG N

SA₃

SAₙ

24

Fig. 2

Fig. 3

Fig. 4

Fig. 5

## Fig. 6a

100

22

IG1'

IG4'

A1        A2        A3        A4

## Fig. 6b

100a

22

IG1'

301a

302a    303a

IG4'

300a

300b

A1        A2        A3        A4

Fig. 7

200

210

EP 2 479 887 A1

Europäisches
Patentamt

European
Patent Office

Office européen
des brevets

**EUROPEAN SEARCH REPORT**

Application Number

EP 11 29 0027

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 18 16 078 A1 (SIEMENS AG) 25 June 1970 (1970-06-25) * page 2, line 1, paragraph 2; figure 1 * * page 6, line 16 - line 27 * ----- | 1,7,8, 10,11 | INV. H03C1/46 H03H9/54 |
| X | US 3 686 593 A (ZAKARIA HISHAM MOHAMED SAADAIL) 22 August 1972 (1972-08-22) * figures 1,9 * ----- | 1,7,10, 11 | |
| X | US 2002/109494 A1 (OLKHOVETS A [US] ET AL OLKHOVETS ANATOLI [US] ET AL) 15 August 2002 (2002-08-15) * paragraph [0025] - paragraph [0026]; figures 1,3 * * paragraph [0018] * ----- | 1,3-11, 13-15 | |
| X | US 4 674 180 A (ZAVRACKY PAUL M [US] ET AL) 23 June 1987 (1987-06-23) * column 7, paragraph 1; figures 9,21 * ----- | 1,2,4,7, 10,11 | |
| A | US 5 780 948 A (LEE KI BANG [KR] ET AL) 14 July 1998 (1998-07-14) * figures 4,8 * ----- | 1-15 | TECHNICAL FIELDS SEARCHED (IPC) H03C H03H |
| A | US 5 856 722 A (HARONIAN DAN [IL] ET AL) 5 January 1999 (1999-01-05) * figures 2,3 * ----- | 1-15 | |

The present search report has been drawn up for all claims

| Place of search | Date of completion of the search | Examiner |
|---|---|---|
| Munich | 20 June 2011 | Schnabel, Florian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

22

**EUROPEAN SEARCH REPORT**

Application Number

EP 11 29 0027

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 18 16 078 A1 (SIEMENS AG) 25 June 1970 (1970-06-25) * page 2, line 1, paragraph 2; figure 1 * * page 6, line 16 - line 27 * | 1,7,8, 10,11 | INV. H03C1/46 H03H9/54 |
| X | US 3 686 593 A (ZAKARIA HISHAM MOHAMED SAADAIL) 22 August 1972 (1972-08-22) * figures 1,9 * | 1,7,10, 11 | |
| X | US 2002/109494 A1 (OLKHOVETS A [US] ET AL OLKHOVETS ANATOLI [US] ET AL) 15 August 2002 (2002-08-15) * paragraph [0025] - paragraph [0026]; figures 1,3 * * paragraph [0018] * | 1,3-11, 13-15 | |
| X | US 4 674 180 A (ZAVRACKY PAUL M [US] ET AL) 23 June 1987 (1987-06-23) * column 7, paragraph 1; figures 9,21 * | 1,2,4,7, 10,11 | |
| A | US 5 780 948 A (LEE KI BANG [KR] ET AL) 14 July 1998 (1998-07-14) * figures 4,8 * | 1-15 | TECHNICAL FIELDS SEARCHED (IPC) H03C H03H |
| A | US 5 856 722 A (HARONIAN DAN [IL] ET AL) 5 January 1999 (1999-01-05) * figures 2,3 * | 1-15 | |

The present search report has been drawn up for all claims

| Place of search | Date of completion of the search | Examiner |
|---|---|---|
| Munich | 20 June 2011 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                                    EP 11 29 0027

This annex lists the patent family members relating to the patent documents cited in the above-mentioned European search report.
The members are as contained in the European Patent Office EDP file on
The European Patent Office is in no way liable for these particulars which are merely given for the purpose of information.

20-06-2011

| Patent document cited in search report | | Publication date | Patent family member(s) | | Publication date |
|---|---|---|---|---|---|
| DE 1816078 | A1 | 25-06-1970 | NONE | | |
| US 3686593 | A | 22-08-1972 | CH | 526246 A | 31-07-1972 |
| | | | DE | 2010196 A1 | 17-09-1970 |
| | | | FR | 2037731 A5 | 31-12-1970 |
| | | | GB | 1277614 A | 14-06-1972 |
| US 2002109494 | A1 | 15-08-2002 | NONE | | |
| US 4674180 | A | 23-06-1987 | NONE | | |
| US 5780948 | A | 14-07-1998 | DE | 19643182 A1 | 30-04-1997 |
| | | | JP | 3816996 B2 | 30-08-2006 |
| | | | JP | 9178494 A | 11-07-1997 |
| US 5856722 | A | 05-01-1999 | NONE | | |

EPO FORM P0459

For more details about this annex : see Official Journal of the European Patent Office, No. 12/82